# DEMANDE DE BREVET EUROPEEN

(11) **EP 0 524 073 A1**
(43) Date de publication de la demande: **20.01.1993**
(21) Numéro de dépôt: 92402002.7
(22) Date de dépôt: 10.07.1992
(51) Int. Cl.: C23C 16/44, F24H 1/10

(54) **Dispositif d'injection d'un produit dans une enceinte telle qu'un réacteur de micro-électronique**

(30) Priorité: 15.07.1991 FR 9108896
(71) Demandeur: FRANCE TELECOM, F-75015 Paris (FR)
(72) Inventeur: Bensahel, Daniel, F 38000 Grenoble (FR); Carre, Rémy, F-38660 Le Touvet (FR); Dutartre, Didier, F-38240 Meylan (FR); Regolini, Jorge, F-38240 Meylan (FR)
(74) Mandataire: Casalonga, Axel

(57) **Abrégé**

Dispositif d'injection d'un produit tel que gaz ou vapeur provenant d'une source en vue de l'alimentation d'une enceinte comprenant un tube enveloppant (11) fixé de façon étanche dans une ouverture (10) de l'enceinte (3) et électriquement conducteur, un conduit d'injection (8) électriquement conducteur qui s'étend sur au moins une partie de sa longueur dans le tube enveloppant, à distance de la paroi de ce dernier, et une paroi de liaison (13) reliant de façon étanche et électriquement lesdits tubes; ledit tube enveloppant, ladite paroi et ledit conduit d'injection constituant un conducteur électrique susceptible d'être relié à une source d'énergie électrique (28) de telle sorte que le passage de courant dans ce conducteur produise par effet Joule au moins l'échauffement du conduit d'injection au travers duquel passe le produit.

## Description

La présente invention concerne un dispositif de projection d'un produit tel que gaz ou vapeur provenant d'une source en vue de l'alimentation d'une enceinte telle qu'un réacteur utilisé par exemple en micro-électronique.

En micro-électronique, on utilise des dépôts métalliques, notamment des siliciures de métaux ou des métaux purs pour l'exécution des interconnexions "intra" ou "inter" puces.

Jusqu'à présent, ces dépôts sont réalisés le plus souvent par évaporation ou pulvérisation cathodique, les matériaux déposés étant ensuite utilisés soit tels quels soit après réaction chimique avec la surface de l'échantillon. Cependant, en général ces dépôts ne sont pas sélectifs de telle sorte que leur utilisation est très limitée. Pour palier ce défaut, on préfèrerait utiliser le dépôt chimique en phase vapeur, par réaction sans pollution d'un gaz contenant le métal à déposer à la surface de l'échantillon.

Cette dernière technique a été développée pour le tungstène qui est actuellement le seul produit utilisé pour effectuer les connexions et interconnexions précitées car WF6 est un gaz qui est maintenant fabriqué de façon très pure et dont la chimie avec le silicium est bien connue. Néanmoins, des problèmes subsistent car ce gaz est très réactif et à tendance à induire des réactions parasites.

On cherche donc à se tourner vers d'autres sources de gaz ou vers d'autres métaux.

On a d'ores et déjà démontré qu'une source solide, où il s'agit de former un halogénure métallique par réaction d'un gaz du type Cl2 ou HCL sur un métal pur est d'autant plus intéressante qu'elle peut être à priori utilisée pour la plupart des métaux. En effet, on sait aujourd'hui fabriquer presque tous les métaux de façon très pure et presque tous les halogénures peuvent être gazeux à condition néanmoins de les chauffer suffisamment, à des températures pouvant aller de 100 à 800°C, leur température devant être maintenue au-dessus d'une valeur suffisante afin d'éviter ou de limiter les pertes par condensation. Cette contrainte de température qui provient des caractéristiques physiques de l'halogénure est aussi bien valable pour les sources liquides que pour les sources solides.

La présente invention a pour objectif de résoudre le problème de la liaison entre une source d'un produit et une enceinte dans laquelle le produit est injecté, en particulier la connexion d'une source d'halogénure et d'un réacteur dans lequel cet halogénure est utilisé pour l'exécution d'un dépôt sur un substrat.

Selon un objet de l'invention, le dispositif d'injection d'un produit tel que gaz ou vapeur provenant d'une source en vue de l'alimentation d'une enceinte telle qu'un réacteur utilisé en micro-électronique, comprend un tube enveloppant fixé de façon étanche dans une ouverture de l'enceinte et électriquement conducteur, un conduit d'injection électriquement conducteur qui s'étend sur au moins une partie de sa longueur dans le tube enveloppant, à distance de la paroi de ce dernier, et une paroi de liaison reliant de façon étanche et électriquement lesdits tubes, ledit tube enveloppant, ladite paroi et ledit conduit d'injection constituant un conducteur électrique susceptible d'être relié à une source d'énergie électrique de telle sorte que le passage de courant dans ce conducteur produise par effet Joule au moins l'échauffement du conduit d'injection au travers duquel passe le produit.

Selon l'invention, la résistance du tube enveloppant et de la paroi de liaison précités est, de préférence, très inférieure à celle du conduit d'injection précité.

Selon l'invention, l'épaisseur du tube enveloppant précité et de la paroi de liaison précitée peut avantageusement être nettement supérieure à celle du conduit d'injection précité.

Selon l'invention, un isolant électrique est de préférence disposé dans l'espace séparant le conduit d'injection et le tube enveloppant précités.

Selon l'invention, ledit conduit d'injection et ledit tube enveloppant sont de préférence reliés par l'une de leurs extrémités adjacentes.

Dans un mode d'exécution préférée, le tube enveloppant précité s'étend au moins en partie à l'intérieur de l'enceinte, ladite paroi de liaison reliant de façon étanche son extrémité intérieure à l'enceinte audit conduit d'injection.

Selon un autre objet de l'invention, une vanne présentant un organe d'obturation est prévue sur le conduit d'injection. Ce conduit présente de préférence au moins deux parties reliées de façon étanche au corps de la vanne et déplaçables l'une par rapport à l'autre de manière à pouvoir être accouplée lorsque l'organe d'obturation est à sa position d'ouverture et en être écartée de manière à mener l'organe d'obturation à sa position de fermeture, au travers de l'espace séparant ces parties.

Lesdites parties dudit conduit d'injection peuvent être avantagement accouplables axialement par contact.

La partie mobile précitée dudit conduit d'injection est de préférence reliée au corps de la vanne par un soufflet.

Ladite partie mobile du conduit d'injection peut avantageusement être reliée à sa partie fixée au tube enveloppant précité par l'intermédiaire d'un conduit souple conducteur de l'électricité.

Dans une exécution préférée de l'invention, la partie d'extrémité dudit conduit d'injection située du côté de la vanne est enveloppée à distance par un tube dont l'une des extrémités est reliée de facon étanche à l'extrémité du conduit d'injection, ce tube étant conducteur de l'électricité et étant inseré dans le conducteur d'électricité précité.

Selon l'invention, la partie d'extrémité dudit conduit d'injection située du côté de la vanne et ledit tube qui l'enveloppe sont de préférence reliés de façon étanche et électriquement par une paroi radiale adaptée pour venir en contact contre l'extrémité de ladite partie fixe du conduit d'injection.

Selon l'invention, il est avantageux que la source d'énergie électrique soit à basse tension et fort ampérage.

La présente invention sera mieux comprise à l'étude d'un dispositif d'injection d'un produit dans une enceinte à partir d'une source, décrit à titre d'exemple non limitatif et illustré par le dessin sur lequel :
- la figure 1 montre schématiquement une coupe du dispositif d'injection selon l'invention dans sa position de fonctionnement ;
- et la figure 2 représente le dispositif précité dans sa position de repos.

Le dispositif d'injection représenté, repéré d'une manière générale par la référence 1, permet de réaliser la liaison entre une source 2, formée par exemple par une enceinte émettrice dans laquelle se forme ou est stocké un produit tel qu'un halogénure et une enceinte réceptrice 3 telle qu'un réacteur dans lequel le produit doit être injecté.

Le dispositif d'injection 1 comprend un conduit d'injection repéré d'une manière générale par la référence 4 qui relie l'enceinte émettrice et l'enceinte réceptrice.

Le conduit d'injection est divisé et comprend, de l'enceinte émettrice 2 à l'enceinte réceptrice 3, un tube de sortie 5, un tube intermédiaire 6, un conduit souple 7, et un tube d'entrée 8.

La paroi 9 de l'enceinte réceptrice 3 présente une ouverture 10 à partir de laquelle s'étend, dans cette enceinte 3, un tube cylindrique enveloppant 11. L'extrémité de ce tube enveloppant 11 située dans cette ouverture 10 est fixée de façon étanche à la paroi 9 par exemple par soudure.

Le tube d'entrée 8 du conduit d'injection 4 s'étend dans le tube enveloppant 11, à distance de la paroi interne de ce dernier, ménageant ainsi un espace annulaire 12.

La partie d'extrémité avant du tube d'entrée 8 traverse une paroi radiale 13 de liaison avec l'extrémité libre du tube enveloppant 11 intérieure à l'enceinte réceptrice 3. Cette paroi radiale de liaison 13 est fixée de façon étanche au tube d'entrée 8 et au tube enveloppant 11 par exemple par soudures.

L'autre extrémité du tube d'entrée 8 débouche à l'extérieur du tube enveloppant 11, au-delà de la paroi 9 de l'enceinte réceptrice 3.

Dans l'exemple, le tube d'entrée 8 et le tube enveloppant 11 sont coudés. Dans l'espace 12 précité, sont disposés deux tubes 14 et 14a qui entourent les deux branches que forme le tube d'entrée 8.

Le tube de sortie 5 et le tube intermédiaire 6 du conduit d'injection 4 sont associés à une vanne repérée d'une manière générale par la référence 15, de la manière suivante.

Dans l'exemple, cette vanne comporte un corps 16 qui présente, de part et d'autre d'une partie évasée creuse 17, deux parties cylindriques 18 et 19 coaxiales formant un canal 17a de diamètre constant ouvert à ses deux extrémités et débouchant de part et d'autre dans la partie creuse 17.

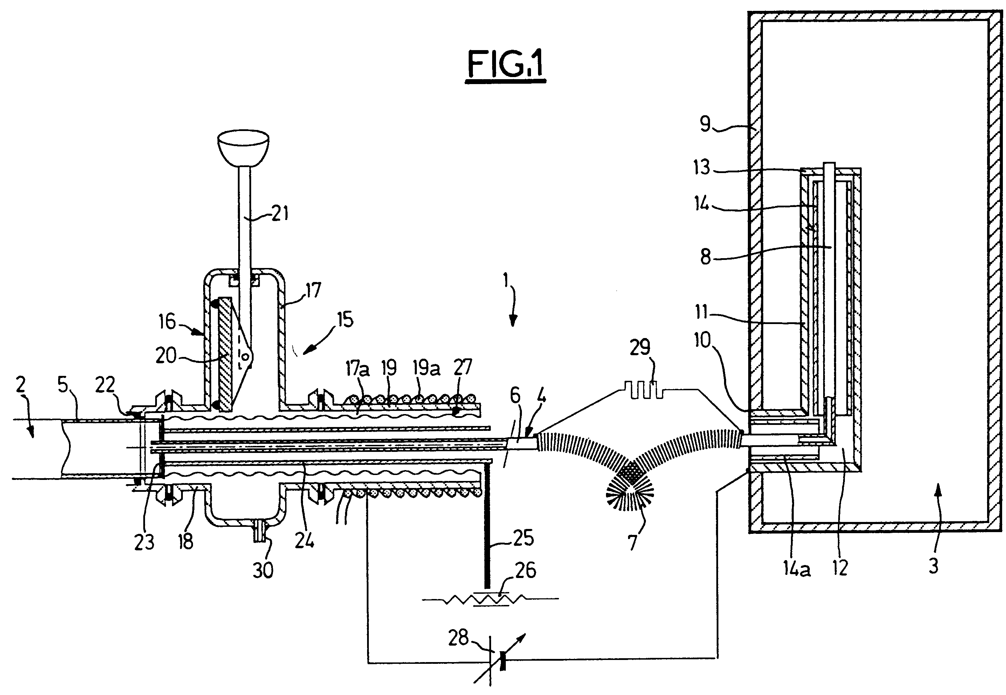

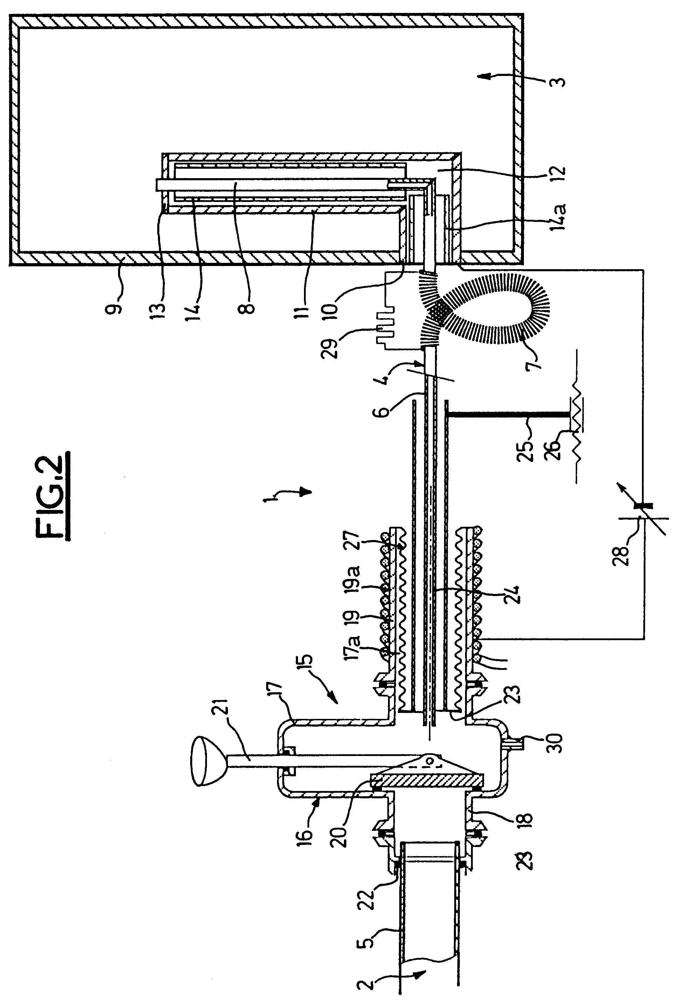

Dans sa partie médiane creuse 17, la vanne 15 présente un organe obturateur 20 déplaçable radialement par l'intermédiaire d'une tige de manoeuvre 21, entre une position de fermeture dans laquelle il obstrue la partie cylindrique 18 comme le montre la figure 2 et une position d'ouverture dans laquelle le canal 17a déterminé par les parties cylindriques 18 et 19 est libre comme le montre la figure1.

L'une des extrémités du tube de sortie 5 du conduit d'injection 4 est connectée à l'enceinte émettrice 2 tandis que son autre extrémité est engagée coaxialement dans la partie cylindrique 18 de la vanne 15, un joint d'étanchéité annulaire 22 étant disposé entre la surface extérieure du tube de sortie 5 et la surface intérieure de la partie cylindrique 18.

Le tube intermédiaire 6 du conduit d'injection 4, qui est disposé coaxialement au tube 5 et qui est de plus petit diamètre, s'étend coaxialement au travers de la partie cylindrique 19 de la vanne 15. Son extrémité située du côté du tube de sortie 5 porte à sa périphérie une rondelle radiale 23 de façon étanche par exemple par soudure à ce tube. Cette rondelle 23 présente un diamètre extérieur supérieur ou égal au diamètre extérieur du tube de sortie 5.

Le tube intermédiaire 6 est entouré à distance par un tube enveloppant 24 dont l'une des extrémités est fixée par exemple par soudure contre la face radiale correspondante de la rondelle 23.

L'autre extrémité de ce tube enveloppant 24 est portée par un bras radial 25 qui s'étend à l'extérieur de la vanne 15 et qui est relié à un moyen d'entraînement longitudinal 26 représenté très schématiquement, constitué par exemple par un système vis-écrou éventuellement motorisé.

Autour et à distance du tube enveloppant 24 et dans le canal 17a est prévu un soufflet cylindrique 27 dont l'une des extrémités est reliée de façon étanche, par exemple par soudure, à la périphérie de la rondelle 23 et dont l'autre extrémité est reliée de façon étanche, par exemple par soudure, à l'extrémité libre de la partie cylindrique 19 de la vanne 15, ce soufflet 27 s'étendant à distance de la paroi intérieure de cette partie cylindrique.

Ainsi, en actionnant le système de déplacement 26, on peut déplacer longitudinalement par rapport à la vanne 15 l'ensemble formé par le tube intermédiaire 6, la rondelle 23 et le tube enveloppant 24, en déformant en même temps le soufflet cylindrique 27.

Lorsque l'obturateur 20 de la vanne 15 est à sa position d'ouverture précitée, on peut donc amener la rondelle 23 en contact axial avec le bord d'extrémité du tube 5, créant ainsi une communication directe entre ce tube 5 et le tube 6. Par déplacement dans le sens opposé, on peut libérer entre le tube 5 et la rondelle 23 un espace tel que l'obturateur 20 peut être amené à sa position de fermeture précitée coupant toute communication entre le tube 5 et le tube 6.

Par ailleurs, l'extrémité du tube intermédiaire 6 opposée à la rondelle 23, qui s'étend à l'extérieur du tube enveloppant 24, est reliée à l'extrémité du tube d'entrée 8 extérieure à l'enceinte réceptrice 3 par l'intermédiaire du tube souple 7 qui permet d'absorber les mouvements précités du tube 6 intermédiaire. Dans l'exemple représenté, le tube intermédiaire 6, le tube souple 7 et le tube d'entrée 8 ont sensiblement le même diamètre.

Dans la position accouplée décrite précédemment, lorsque la vanne 15 est à sa position d'ouverture, comme représentée sur la figure 1, on obtient en conséquence une continuité du conduit d'injection 4 entre l'enceinte émettrice 2 et l'enceinte réceptrice 3, au-travers des tubes 5, 6, 7 et 8. On peut donc considérer que le conduit d'injection 4 est, structurellement, quasiment isolé thermiquement du corps extérieur de la vanne 15. Dans la position désaccouplée décrite précédemment, lorsque la vanne 15 est à sa position de fermeture, le conduit d'injection 4 est fermé.

Dans l'exemple, le tube enveloppant 11, la paroi radiale 13, le tube 8, le tube 7, le tube 6, la rondelle 23, le tube enveloppant 24, le soufflet 27 et la partie cylindrique 19 de la vanne 15 et leurs liaisons, par exemple par soudure comme on l'a vu précédemment, sont en des matériaux conducteurs de l'électricité, constituant ainsi un conducteur électrique.

Ainsi, en branchant une source réglable d'énergie électrique 28 entre le tube enveloppant 11 et la partie cylindrique 19 de la vanne 15, on peut faire passer un courant électrique dans le conducteur électrique ainsi formé.

Entre le tube intermédiaire 6 et le tube d'entrée 8, on peut de plus prévoir un shunt 29 en parallèle au tube souple 7.

La source d'énergie électrique fournissant de préférence un courant de faible tension et de fort ampérage, il se produit par effet Joule notamment un échauffement des tubes 6, 7 et 8 du conduit d'injection 4, permettant ainsi d'agir sur la température du produit transférée par le conduit d'injection 4 depuis l'enceinte émettrice 2 jusqu'à l'enceinte réceptrice 3.

On peut en outre faire en sorte que le tube enveloppant 11 qui entoure le tube d'entrée 8 s'échauffe nettement moins que ce dernier en prévoyant par exemple un tube 11 et une paroi radiale 13 présentant des caractéristiques électriques différentes de celles du tube d'entrée 8 et en particulier des épaisseurs nettement supérieures. Ainsi, on peut considérer que le conduit d'injection 4 est thermiquement isolé de l'ambiance intérieure de l'enceinte de réception 3 et de la paroi de cette dernière.

Par ailleurs, la partie cylindrique 19 de la vanne 15 est entourée par un tube en serpentin 19a dans lequel on peut faire circuler un fluide de refroidissement de cette dernière.

En outre, la partie centrale creuse 17 du corps de la vanne 15 est équipée d'un embout de connexion 30 qui peut être utilisé pour l'amenée d'un produit dans l'enceinte réceptrice 3 lorsque la rondelle 23 est écartée du tube 5 et lorsque l'obturateur est à sa position de fermeture comme on la décrit précédemment.

Dans l'application particulière du dispositif d'injection décrit ci-dessus à l'alimentation d'une enceinte réceptrice 3 constituant un réacteur en produits tels que des halogénures mis en oeuvre dans l'enceinte émettrice 2, au travers du conduit d'injection 4 maintenant leur température afin d'éviter leur condensation, on peut prévoir les caractéristiques supplémentaires suivantes.

Dans cette application, le conduit d'injection 4 doit résister aux espèces à transporter de la source 2 au réacteur 3.

Le tube d'isolation électrique 14 doit pouvoir supporter des hautes températures et est de préférence en quartz ou en tout autre matière isolant électrique.

Le tube enveloppant 11 doit résister aux espèces chimiques présentes dans le réacteur 3.

Les sections et matières des tubes 8 et 11 et leurs caractéristiques électriques seront calculées pour provoquer l'échauffement du tube intérieur 8 de façon nettement plus conséquente que celui du tubes enveloppant 11. Dans ce cas, l'étanchéité entre le tube enveloppant 11 et la paroi 9 du réacteur 3 qui sont à des températures non élevées pourra être réalisée d'une manière quelconque par soudure comme il l'a été prévu précédemment ou bien par joint.

Une Amélioration peut être obtenue également en rajoutant un contre-tube réfractaire et inerte à l'intérieur du tube 8 dans les cas où le gaz réagirait avec ce tube.

Si l'on veut de plus éviter toute pollution dans le conduit d'injection 4, on peut en outre être amené à tapisser l'intérieur par un dépôt adéquat, par exemple un siliciure du métal à transporter.

Dans une autre exécution, on peut être également mener à refroidir le tube enveloppant 11 par exemple en le remplaçant par un double tube avec circulation d'eau à l'intérieur.

Le dispositif d'injection qui vient d'être décrit est particulièrement bien adapté pour le transport de toute vapeur à base de W, Ti, Cu, Fe, Er, Ta et trouve une application immédiate dans la fabricationdes siliciures métalliques dans le domaine de la microélectronique silicium.

D'autres domaines d'application du dispositif de l'invention peuvent également être envisagé, notamment le domaine électroménager.

## Revendications

1. Dispositif d'injection d'un produit tel que gaz ou vapeur provenant d'une source en vue de l'alimentation d'une enceinte, caractérisé par le fait qu'il comprend un tube enveloppant (11) fixé de façon étanche dans une ouverture (10) de l'enceinte (3) et électriquement conducteur, un conduit d'injection (8) électriquement conducteur qui s'étend sur au moins une partie de sa longueur dans le tube enveloppant, à distance de la paroi de ce dernier, et une paroi de liaison (13) reliant de façon étanche et électriquement lesdits tubes; ledit tube enveloppant, ladite paroi et ledit conduit d'injection constituant un conducteur électrique susceptible d'être relié à une source d'énergie électrique de telle sorte que le passage de courant dans ce conducteur produise par effet Joule au moins l'échauffement du conduit d'injection au travers duquel passe le produit.

2. Dispositif d'injection selon la revendication 1, caractérisé par le fait que la résistance du tube enveloppant (11) et de la paroi de liaison (13) précités est très inférieure à celle du conduit d'injection (8) précité.

3. Dispositif d'injection selon l'une des revendications 1 et 2, caractérisé par le fait que l'épaisseur du tube enveloppant (11) précité et de la paroi de liaison (13) précitée est nettement supérieure à celle du conduit d'injection (8) précité.

4. Dispositif d'injection selon l'une quelconque des revendications précédentes, caractérisé par le fait que dans l'espace séparant le conduit d'injection et le tube enveloppant précités est disposé un isolant électrique (14, 14a).

5. Dispositif selon l'une quelconque des revendications précédentes, caractérisé par le fait que ledit conduit d'injection (8) et ledit tube enveloppant (11) sont reliés par l'une de leurs extrémités adjacentes.

6. Dispositif d'injection selon l'une quelconque des revendications précédentes, caractérisé par le fait que le tube enveloppant (11) précité s'étend au moins en partie à l'intérieur de l'enceinte (3), ladite paroi de liaison (13) reliant de façon étanche son extrémité intérieure à l'enceinte audit conduit d'injection (8).

7. Dispositif d'injection selon l'une quelconque des revendications précédentes, caractérisé par le fait que sur le conduit d'injection (4) est prévu une vanne (15) présentant un organe d'obturation (20), ce conduit (4) présentant au moins deux parties (5, 6) reliées de façon étanche au corps de la vanne et déplaçables l'une par rapport à l'autre de manière à pouvoir être accouplée lorsque l'organe d'obturation est à sa position d'ouverture et en être écartée de manière à amener l'organe d'obturation à sa position de fermeture, au travers de l'espace séparant ces parties.

8. Dispositif d'injection selon la revendication 7, caractérisé par le fait que lesdites parties (5 ,6) dudit conduit d'injection (4) sont accouplables axialement par contact.

9. Dispositif selon l'une des revendications 7 et 8, caractérisé par le fait la partie mobile (6) précitée dudit conduit d'injection est reliée au corps de la vanne par un soufflet (27).

10. Dispositif d'injection selon l'une quelconque des revendications précédentes, caractérisé par le fait que ladite partie mobile du conduit d'injection est reliée à sa partie (8) fixée au tube enveloppant (11) précité par l'intermédiaire d'un conduit souple (7) conducteur de l'électricité.

11. Dispositif d'injection selon la revendication 10, caractérisé par le fait qu'au moins la partie d'extrémité dudit conduit d'injection (4) située du côté de la vanne (15) est enveloppée à distance par un tube (24) dont l'une des extrémités est reliée de facon étanche à l'extrémité du conduit d'injection, ce tube étant conducteur de l'électricité et étant inserré dans le conducteur d'électricité précité.

12. Dispositif selon la revendication 11, caractérisé par le fait que la partie d'extrémité dudit conduit d'injection (4) située du côté de la vanne et ledit tube qui l'enveloppe sont reliés de façon étanche et électriquement par une paroi radiale (23) adaptée pour venir en contact contre l'extrémité de ladite partie fixe du conduit d'injection.

13. Dispositif selon l'une quelconque des revendications précédentes, caractérisé par le fait que la source d'énergie électrique (28) est à basse tension et fort ampérage.

14. Dispositif selon l'une quelconque des revendications précédentes, caractérisé par le fait que ladite enceinte (3) est un réacteur utilisé en micro-électronique.
